# EUROPÄISCHE PATENTANMELDUNG

(11) **EP 4 708 055 A1**
(43) Veröffentlichungstag der Anmeldung: **11.03.2026**
(21) Anmeldenummer: 24198570.4
(22) Anmeldetag: 05.09.2024
(51) Int. Cl.: G06F 11/26, G06F 11/3668, G06F 11/3698, G06F 30/20

(54) **VERFAHREN ZUR DURCHFÜHRUNG EINER SIL-SIMULATION, VORRICHTUNG ZUR DATENVERARBEITUNG ZUM DURCHFÜHREN EINER SIL-SIMULATION, COMPUTERPROGRAMMPRODUKT, SIGNALFOLGE UND SIMULATIONSPLATTFORM**

(71) Anmelder: dSPACE GmbH, 33102 Paderborn (DE)
(72) Erfinder: Süvern, Markus, 33102 Paderborn (DE); Menne, Benedikt, 33102 Paderborn (DE)

(57) **Zusammenfassung**

Die vorliegende Erfindung betrifft ein Verfahren zur Durchführung einer auf einer Host-Datenverarbeitungsvorrichtung laufenden SIL-Simulation sowie eine Vorrichtung zur Datenverarbeitung zum Durchführen einer SIL-Simulation, wobei die Vorrichtung Mittel aufweist, die dazu eingerichtet sind, ein solches Verfahren auszuführen. Die vorliegende Erfindung betrifft auch ein Computerprogrammprodukt, eine Signalfolge und eine Simulationsplattform.

## Beschreibung

### Bezeichnung der Erfindung

Verfahren zur Durchführung einer SIL-Simulation, Vorrichtung zur Datenverarbeitung zum Durchführen einer SIL-Simulation, Computerprogrammprodukt, Signalfolge und Simulationsplattform

### Gebiet der Technik

Die vorliegende Erfindung betrifft ein Verfahren zur Durchführung einer auf einer Host-Datenverarbeitungsvorrichtung laufenden SIL-Simulation sowie eine Vorrichtung zur Datenverarbeitung zum Durchführen einer SIL-Simulation, wobei die Vorrichtung Mittel aufweist, die dazu eingerichtet sind, ein solches Verfahren auszuführen. Die vorliegende Erfindung betrifft auch ein Computerprogrammprodukt, eine Signalfolge und eine Simulationsplattform.

### Stand der Technik

Bei der Entwicklung elektronischer Steuergeräte sind Validierungen der auf einer Ziel-Hardware ausgeführten Steuergeräte-Software integraler Bestandteil des Entwicklungsprozesses. Beispielsweise kann mittels "Software-in-the-Loop"-Simulationen, sogenannter SIL-Simulationen, das Verhalten der jeweiligen Steuergeräte-Software oder Teile davon in einer simulierten Umgebung in jeweils verschiedenen Entwicklungsphasen getestet werden. Hierzu kann die zu testende Software auf einer geeigneten Simulationsplattform als virtuelles Steuergerät implementiert und das virtuelle Steuergerät innerhalb eines Simulationsszenarios simuliert werden. Neben bestimmten Funktionen einer Ziel-Hardware können dabei auch Sensorsignale und andere Simulationsteilnehmer im jeweils erforderlichen Umfang simuliert werden.

Für bestimmte Testszenarien kann es jedoch erforderlich sein, die Steuergeräte-Software während eines Resetereignisses zu simulieren. Ein Beispiel für ein solches Resetereignis ist ein Aufruf zum Reset der Ziel-Hardware des virtuellen Steuergerätes. Die Ziel-Hardware ist jedoch bei der SIL-Simulation nicht vorhanden und die Durchführung eines entsprechenden Resetereignisses kann mit bisherigen Hardware-Modellen nicht oder nicht zufriedenstellend im Rahmen einer SIL-Simulation simuliert werden. Es ist daher wünschenswert, mittels einer SIL-Simulation ein virtuelles Steuergerät während eines Resetereignisses in einfacher aber dennoch zuverlässiger Weise simulieren zu können.

### Zusammenfassung der Erfindung

Es ist daher Aufgabe der vorliegenden Erfindung, die beschriebenen Nachteile des Stands der Technik zu überwinden und insbesondere Mittel anzugeben, mit denen im Rahmen einer SIL-Simulation ein virtuelles Steuergerät während eines Resetereignisses in einfacher aber dennoch zuverlässiger simuliert werden kann.

Die Aufgabe wird durch die Erfindung gemäß einem **ersten Aspekt** dadurch gelöst, dass ein Verfahren zur Durchführung einer auf einer Host-Datenverarbeitungsvorrichtung laufenden SIL-Simulation vorgeschlagen wird. Durch die Simulation wird ein virtuelles Steuergerät innerhalb eines Simulationsszenarios simuliert, wobei das Simulationsszenario ein Eintritt eines Resetereignisses aufweist, und wobei das Simulieren des Resetereignisses aufweist, dass zumindest ein erster Speicherbereich zumindest einer Speichereinheit der Host-Datenverarbeitungsvorrichtung zumindest teilweise auf ein vordefiniertes Speicherabbild gesetzt wird.

Der Erfindung liegt damit die überraschende Erkenntnis zugrunde, dass durch eine zumindest teilweise Trennung von Speicherbereichen der Host-Datenverarbeitungsvorrichtung gezielt Inhalte von bestimmten Speicherbereichen mit einer Zugehörigkeit zu der zu testenden Steuergeräte-Software des virtuellen Steuergeräts verändert werden können. Dadurch ist es überraschend einfach möglich, einen Verlauf der SIL-Simulation zu bewirken, der zumindest teilweise ein Verhalten eines realen Steuergerätes unter einem Einfluss eines realen Resetereignisses zumindest in Teilen wirklichkeitsnah nachbildet.

Vorteilhafterweise ist dazu zumindest der erste Speicherbereich der Host-Datenverarbeitungsvorrichtung mit einer Zugehörigkeit zumindest einiger der darin gespeicherten Inhalte zu der zu testenden Steuergeräte-Software im Vorfeld der Simulation als der erste Speicherbereich festgelegt. Beispielsweise ist der erste Speicherbereich vorab und/oder zum Start der Simulation definiert. Dadurch ist der Speicherbereich bekannt und kann für das Setzen des vordefinierten Speicherabbildes leicht datentechnisch angesprochen werden. Insbesondere sind eine oder mehrere Speicheradressen des ersten Speicherbereichs bekannt, so dass auf den ersten Speicherbereich lesend und/oder schreibend zugegriffen werden kann. Durch das Setzen des ersten Speicherbereichs auf das vordefinierte Speicherabbild kann die zu testende Steuergeräte-Software innerhalb der Simulation auf eine Weise beeinflusst werden, die im Ergebnis den Einfluss eines realen Resetereignisses auf die auf einem realen Steuergerät ausgeführten Steuergeräte-Software zumindest in Teilen entspricht.

Da das Setzen des ersten Speicherbereichs auf das vordefinierte Speicherabbild eine außerhalb der Simulation (des simulierten Szenarios) durchgeführte Maßnahme darstellt, kann folglich durch das Setzen des ersten Speicherbereichs auf das vordefinierte Speicherabbild von außerhalb der Simulation Einfluss auf den Verlauf der Simulation genommen werden.

In dieser Anmeldung wird die Phrase "... innerhalb der Simulation ..." insbesondere im Zusammenhang damit verwendet, "was" simuliert wird (in Abgrenzung zu "wie/mit welchen Mitteln" etwas simuliert wird), sofern sich aus dem jeweiligen Zusammenhang nichts anderes ergibt. Es wird also auf das simulierte Szenario Bezug genommen. In ganz ähnlicher Weise wird in dieser Anmeldung die Phrase "als Teil der Simulation ... ausgeführt" verwendet.

In dieser Anmeldung wird die Phrase "...außerhalb der Simulation ..." insbesondere im Zusammenhang damit verwendet, "wie/mit welchen Mitteln" das, was simuliert wird oder werden soll, simuliert wird, sofern sich aus dem jeweiligen Zusammenhang nichts anderes ergibt. Es wird also auf die jeweilige Maßnahme Bezug genommen. Dennoch kann die jeweilige Maßnahme mittelbar auch Einfluss auf das haben, "was" simuliert wird.

Beispielsweise kann das vordefinierte Speicherabbild ein Snapshot des ersten Speicherbereichs sein, wobei der Snapshot vorzugsweise zu einem Zeitpunkt, der vor dem Start und/oder zu Beginn der Simulation liegt, erstellt wurde. Insbesondere können vor dem Start der Simulation und/oder zu Beginn der Simulation alle zur zu testenden Steuergeräte-Software gehörenden Variablenwerte mittels des Snapshots gesichert werden. Der Snapshot kann dann als das vordefinierte Speicherabbild verwendet werden.

Durch das vordefinierte Speicherabbild können beispielsweise ein oder mehrere Variablen der zu testenden Steuergeräte-Software jeweils auf einen definierten Wert gemäß dem vordefinierten Speicherabbild gesetzt werden. Auf diese Weise ist es besonders einfach möglich, gezielt die Variablen der zu testenden Steuergeräte-Software auf einen definierten Wert (gemäß dem vordefinierten Speicherabbild) zu setzen, ohne dabei Variablen der Simulation als solches (wie etwa eine Schrittweite oder eine Simulationsdauer) zu ändern oder zurückzusetzen.

Besonders hervorzugeben ist in diesem Zusammenhang, dass mit dem vorgeschlagenen Verfahren das Resetereignis vorteilhaft auch ohne Kenntnis des Programmcodes des virtuellen Steuergeräts, und insbesondere der zu testenden Steuergeräte-Software, simuliert werden kann. Insbesondere müssen keine Variablen innerhalb des Programmcodes der zu testenden Steuergeräte-Software vorab bekannt sein und/oder speziell definiert werden, um das Resetereignis simulieren zu können. Es muss also beispielsweise nicht notwendig sein, Einsicht in den Programmcode zu nehmen. Dadurch ist das vorgeschlagene Verfahren besonders universell einsetzbar und die Simulation ist für die Anwender besonders einfach und ohne nähere Kenntnisse zu dem Programmcode des virtuellen Steuergerätes, insbesondere zu der zu testenden Steuergeräte-Software, durchführbar. Es genügt insoweit die Kenntnis über den ersten Speicherbereich, ohne dass die einzelnen Variablen, die mit den Inhalten des ersten Speicherbereichs belegt werden, bekannt sein müssten.

Außerdem und vor allem kann das virtuelle Steuergerät, einschließlich der zu testenden Steuergeräte-Software, dadurch vorteilhaft auch zumindest teilweise in einem binären Format bereitgestellt werden, in welchem Fall eine Einsichtnahme in den Programmcode der zu testenden Steuergeräte-Software ohnehin nicht oder nur unter erschwerten Bedingungen möglich ist. Dadurch ist die Flexibilität hinsichtlich der möglichen Datenformate deutlich gesteigert. Vorzugsweise wird daher das virtuelle Steuergerät für die Simulation zumindest teilweise in einem binären Format bereitgestellt. Beispielswiese kann das virtuelle Steuergerät hierzu zumindest teilweise als zumindest eine *.lib-Datei und/oder zumindest eine *.obj-Datei bereitgestellt werden.

Durch das vorgeschlagene Verfahren wird es außerdem vorteilhaft ermöglicht, dass während des Resetereignisses die Simulation weiterläuft, ohne dass diese angehalten wird. Dadurch können während der Simulation bestehende Verbindungen zu einer Simulationsumgebung und/oder zu Experimentiertools auch während des Resetereignisses durchgehend aufrechterhalten werden.

Vorzugsweise ist die zu testende Steuergeräte-Software und/oder das virtuelle Steuergerät Teil des Simulationsszenarios. Vorteilhafterweise ist das virtuelle Steuergerät ein virtuelles elektronisches Steuergerät. Beispielsweise kann die zu testende Steuergeräte-Software eine Software sein, die auf einem elektronischen Steuergerät für ein Kraftfahrzeug ausführbar ist. Das Steuergerät, für das die zu testende Steuergeräte-Software bestimmt ist, kann beispielsweise ein elektronisches Steuergerät, insbesondere für ein Kraftfahrzeug, sein.

Vorteilhafterweise betrifft das Simulationsszenario ein Szenario aus dem Bereich der Functional-Safety, insbesondere im Kraftfahrzeugbereich.

Besonders vorteilhaft ist dabei, dass mit virtuellen Steuergeräten eine Steuergeräte-Software (oder Teile davon) einschließlich der Kommunikation zwischen mehreren Steuergeräten getestet werden kann, noch bevor Hardware-Prototypen der Ziel-Hardware zur Verfügung stehen bzw. ohne, dass diese zur Verfügung stehen müssen. Auf diese Weise kann schon während der Software-Entwicklung und parallel zu bzw. entkoppelt von der Hardware-Entwicklung unter realistischen Bedingungen das Verhalten der Steuergeräte-Software und vor allem auch Teile davon simuliert und basierend auf den Simulationsergebnissen etwaig notwendige Anpassungen an der Software vorgenommenen werden. Dies kann den Entwicklungsprozess beschleunigen.

Für die Durchführung der SIL-Simulation kann vorzugsweise eine Simulationsplattform eingesetzt werden. In dieser können dann beispielsweise sowohl ein Modell der Ziel-Hardware (also zumindest die für die Simulation der zu testenden Software notwendige Funktionalität der Ziel-Hardware) als auch die zu testende Steuergeräte-Software als virtuelles Steuergerät bereitgestellt, beispielsweise in diese eingeladen, werden. Durch das Hardware-Modell können vorteilhaft zumindest einige Komponenten und/oder Funktionen der Ziel-Hardware, insbesondere zumindest diejenigen, die mit der zu testenden Steuergeräte-Software gemäß dem Simulationsszenario wechselwirken, für die Simulation bereitgestellt werden. Im Ergebnis sorgt das Modell der Ziel-Hardware mit anderen Worten dafür, dass die zu testende Steuergeräte-Software an ihren Schnittstellen innerhalb der Simulation die Ziel-Hardware "sieht", obwohl die reale Ziel-Hardware bei der Simulation gar nicht vorhanden ist. Auf die Bereitstellung solcher Modelle sowie auf vorteilhafte Simulationsplattformen wird weiter unten noch im Detail eingegangen. Alle dort beschriebenen Eigenschaften von Simulationsplattformen können einzeln und in beliebiger Kombination bei der für die Durchführung der SIL-Simulation gemäß dem vorgeschlagenen Verfahren eingesetzten Simulationsplattform vorgesehen sein.

Für den Fachmann ist es bekannt, dass ein reales elektronisches Steuergerät typischerweise zumindest einen Mikrokontroller und zumindest eine Speichereinheit (insbesondere zumindest einen Arbeitsspeicher, RAM) aufweist, wobei auf dem Mikrokontroller eine Software ausgeführt wird oder ausführbar ist, welche Software ein oder mehrere Anwendungsprogramme, eine oder mehrere Betriebssoftware und/oder eine oder mehrere Schichten für eine Kommunikation mit Hardware (insbesondere mit dem Mikrokontroller) aufweist. Dieser Software kann die mit dem vorgeschlagenen Verfahren im Rahmen der Simulation ausgeführte zu testende Steuergeräte-Software zumindest teilweise entsprechen. Ein "elektronisches Steuergerät" wird häufig auch als "ECU" abgekürzt, was für "electronic control unit" steht. Ein virtuelles Steuergerät wird entsprechend auch als "V-ECU" abgekürzt.

Das simulierte Resetereignis stellt vorteilhaft ein Reset eines Mikrokontrollers dar. Unter einem Reset wird beispielsweise ein Zurücksetzen von einem oder mehreren Variablenwerten der jeweiligen Software, im vorliegenden Fall also insbesondere der zu testenden Steuergeräte-Software, verstanden.

Das Verfahren kann vorteilhaft das Bereitstellen der Host-Datenverarbeitungsvorrichtung, auf der die SIL-Simulation durchgeführt wird, aufweisen.

Im Rahmen dieser Anmeldung wird unter einem virtuellen Steuergerät (V-ECU) insbesondere eine Kombination aus der zu testenden Steuergeräte-Software, oder Teile davon, und einer Abstraktion einer Ziel-Hardware für die zu testenden Steuergeräte-Software verstanden. Die Abstraktion der Ziel-Hardware (teilweise auch als Hardware-Modell bezeichnet) kann Funktionalitäten der Ziel-Hardware innerhalb der Simulation bereitstellen. Ein virtuelles Steuergerät weist vorteilhaft Komponenten von Applikations- und/oder Basis-Software auf. Beispielsweise kann das virtuelle Steuergerät eine, insbesondere automatisch generierte, Laufzeitumgebung und/oder ein Betriebssystem aufweisen. Vorzugsweise bietet das virtuelle Steuergerät Funktionalitäten, die mit denen echter Steuergeräte vergleichbar sind.

Im Rahmen dieser Anmeldung wird unter einem Simulationsszenario insbesondere eine Steuergeräte-Testsequenz verstanden. Die Steuergeräte-Testsequenz kann beispielsweise eine Testfahrt eines Kraftfahrzeugs simulieren. Unter dieser kann die Steuergeräte-Software dann vorteilhaft validiert werden. Das Simulationsszenario kann auch aufweisen, dass Informationen mit anderen Simulationsteilnehmern und/oder mit weiteren Modellen, etwa einem Umgebungsmodell und/oder einem Motormodell, ausgetauscht werden, insbesondere Daten von diesen empfangen und/oder Daten an diese gesendet werden. Beispielsweise können in diesem Zusammenhang simulierte Sensordaten in der Simulation bereitgestellt und/oder verwendet werden. Wenn also davon gesprochen wird, dass das virtuelle Steuergerät innerhalb eines Simulationsszenarios simuliert wird, bedeutet dies beispielsweise, dass sich aus Sicht des virtuellen Steuergerätes dessen Umgebung nach zumindest teilweise vordefinierten Regeln ändert, beispielsweise können die vordefinierten Regeln dann gerade die erwähnte Testfahrt beschreiben.

Im Rahmen dieser Anmeldung wird unter einer Ziel-Hardware insbesondere eine Hardware, vorzugsweise aufweisend zumindest einen Mikrokontroller, eines elektronischen Steuergerätes verstanden, auf der eine Steuergeräte-Software, insbesondere aufweisend zumindest Teile der zu testenden Steuergeräte-Software, ausführbar ist.

Im Rahmen dieser Anmeldung wird unter einem Speicherbereich insbesondere ein (logisch) zusammenhängender Abschnitt einer Speichereinheit, zum Beispiel ein Arbeitsspeicher (RAM), eines Computers (wie der Host-Datenverarbeitungsvorrichtung) verstanden. Insbesondere der erste Speicherbereich ist beispielsweise festgelegt oder festlegbar durch zumindest eine Speicheradresse, insbesondere zumindest eine Startadresse und/oder zumindest eine Endadresse.

Es sei an dieser Stelle noch darauf hingewiesen, dass unter einem Resetereignis im Sinne dieser Anmeldung nicht ein Neustart des virtuellen Steuergerätes und/oder der Simulation als solches gemeint ist. Für solche (hier nicht gemeinten) Resets müssen häufig auch ein oder mehrere Simulationsteilnehmer zurückgesetzt werden.

Die zu testende Steuergeräte-Software kann auch als "Software under Test", oder kurz "SUT" bezeichnet werden.

Zusammenfassend kann gesagt werden, dass mit dem vorgeschlagenen Verfahren eine zu testende Steuergeräte-Software, die zur Ausführung auf elektronischen Steuergeräten bestimmt ist, während eines Resetereignisses auf einfache Weise aber dennoch effizient und realitätsnah im Rahmen einer SIL-Simulation simuliert werden kann. Durch die SIL-Simulation gemäß dem vorgeschlagenen Verfahren können vorteilhaft Software-Funktionen, virtuelle Steuergeräte oder komplette Netzwerke virtueller Steuergeräte simuliert und somit getestet werden. Ein virtuelles Steuergerät, wie es vorliegend innerhalb der Simulation eingesetzt wird, kann in diesem Zusammenhang daher auch vorteilhaft als Simulationsmodell verstanden werden.

Alternativ oder ergänzend kann auch vorgesehen sein, dass in dem ersten Speicherbereich, insbesondere ausschließlich, erste Informationen gespeichert werden, die vorzugsweise Konfigurationsinformationen einer zu testenden Steuergeräte-Software, die Teil des virtuellen Steuergerätes ist, innerhalb der Simulation darstellen, wobei vorzugsweise die ersten Informationen Variablenwerte von Variablen der zu testenden Steuergeräte-Software innerhalb der Simulation sind.

Dadurch können durch eine Manipulation des ersten Speicherbereichs gezielt die ersten Informationen und damit beispielsweise Konfigurationsinformationen der zu testenden Steuergeräte-Software manipuliert, insbesondere zumindest teilweise geändert, werden. Dazu müssen die konkreten Variablen des virtuellen Steuergerätes vorteilhaft nicht bekannt sein.

Durch einen vordefinierten ersten Speicherbereich können Informationen der zu testenden Steuergeräte-Software besonders einfach und zuverlässig von übrigen Informationen und damit bezüglich ihrer Zugehörigkeit getrennt werden. Dadurch kann zumindest der eine erste Speicherbereich, in dem zu der zu testenden Steuergeräte-Software gehörige Inhalte abgespeichert werden, zur Laufzeit der Simulation vorteilhaft zuverlässig identifiziert werden.

Indem in dem ersten Speicherbereich ausschließlich erste Informationen gespeichert werden, die beispielsweise Konfigurationsinformationen der zu testenden Steuergeräte-Software innerhalb der Simulation darstellen, ist sichergestellt, dass durch das Setzen des ersten Speicherbereichs auf das vordefinierte Speicherabbild keine Daten von anderen Simulations-Komponenten oder anderen Anwendungen verändert werden. Dadurch ist das Verfahren besonders effizient und zuverlässig ausführbar.

Eine Änderung der ersten Informationen in dem ersten Speicherbereich führt vorteilhaft zu einer Änderung des Modells des virtuellen Steuergerätes innerhalb der Simulation.

Unter Konfigurationsinformationen werden beispielsweise die folgenden Informationen verstanden: Zustandsvariablen, wie Betriebszeiten, Kilometerstände und/oder Regelabweichungen; und/oder Zugriffsrechte für die Abfrage von Fehlerspeichern und/oder für das Verstellen von Parametern.

Alternativ oder ergänzend kann auch vorgesehen sein, dass alle innerhalb der Simulation verwendeten Konfigurationsinformationen und/oder alle Variablen der zu testenden Steuergeräte-Software in dem ersten Speicherbereich gespeichert werden.

Dadurch ist es besonders einfach möglich, die zu testende Steuergeräte-Software mittels des vordefinierten Speicherabbildes zuverlässig auf eine vordefinierte Konfiguration zu setzen.

Alternativ oder ergänzend kann auch vorgesehen sein, dass durch das Resetereignis des Simulationsszenarios ein, insbesondere in Reaktion auf ein Watchdog-Ereignis durchgeführter, Reset einer Ziel-Hardware der zu testenden Steuergeräte-Software und/oder ein Software-Reset zum Neueinlesen von Variablenwerten von Variablen der zu testenden Steuergeräte-Software simuliert wird.

Auf diese Weise kann das Verhalten der zu testenden Steuergeräte-Software hinsichtlich einer sog. Functional-Safety nach einem Resetereignis (wie eben einem Watchdog-Ereignis oder Software-Reset-Ereignis) vorteilhaft überprüft und validiert werden.

Ein Watchdog bezeichnet dabei eine dem Fachmann wohlbekannte Funktion zur Ausfallerkennung eines Systems, wie etwa einem elektronischen Steuergerät bei Kraftfahrzeugen. Wenn beispielsweise eine periodische Rückmeldung einer Software des Systems an den Watchdog nicht oder nicht ordnungsgemäß erfolgt, kann dieser anhand dessen auf eine Fehlfunktion der Software oder einer anderen Komponente des Systems schließen und daraufhin geeignete Maßnahmen zur Behebung der Fehlfunktion einleiten. Eine mögliche Maßnahme kann ein Reset einer Hardware des Systems, auf der die jeweilige Software läuft darstellen. Insoweit kann folglich im Fall von elektronischen Steuergeräten bei Ausbleiben einer Rückmeldung einer Steuergeräte-Software des elektronischen Steuergerätes ein Watchdog-Ereignis ausgelöst werden, woraufhin ein Reset des elektronischen Steuergerätes durchgeführt wird. Mit dem vorgeschlagenen Verfahren kann das virtuelle Steuergerät (und damit insbesondere die zu testende Steuergeräte-Software) besonders vorteilhaft unter einem solchen Resetereignis simuliert werden.

Gleichermaßen kann das Resetereignis den erwähnten Software-Reset simulieren. Ein Software-Reset kann beispielsweise nach dem Ändern von Parametern in der zu testenden Steuergeräte-Software und/oder zur Beschleunigung nacheinander durchgeführter Simulationen mit verschiedenen Testszenarien vorgesehen sein.

Vorteilhaft weist das Resetereignis einen Hardware-Reset und/oder einen Software-Reset auf.

Alternativ oder ergänzend kann auch vorgesehen sein, dass, vorzugsweise vor dem Simulieren des Resetereignisses und/oder vor dem Start der Simulation, das Speicherabbild des ersten Speicherbereichs angefertigt wird.

Beispielsweise kann ein Snapshot des ersten Speicherbereichs aufgenommen werden, um das Speicherabbild anzufertigen. Damit liegt ein vordefiniertes Speicherabbild vor, das beim Simulieren des Resetereignisses entsprechend eingesetzt werden kann.

Auf diese Weise kann das vordefinierte Speicherabbild besonders einfach und dennoch zuverlässig mit für das Resetereignis zu verwendenden Standardwerten für die zu testende Steuergeräte-Software erhalten und für die Simulation des Resetereignisses verwendet werden. Vor allem kann auf diese Weise vorteilhaft erreicht werden, dass das vordefinierte Speicherabbild für unterschiedliche und/oder nacheinander durchgeführte Simulationen die jeweils richtigen Daten enthält. Denn durch die vorgeschlagene Vorgehensweise können in dem angefertigten Speicherabbild gerade diejenigen Informationen enthalten sein, die für die jeweils simulierte zu testende Steuergeräte-Software zu Beginn der Simulation vorgegeben werden.

Alternativ oder ergänzend kann auch vorgesehen sein, dass das Simulieren des Resetereignisses aufweist, dass als Teil der Simulation zumindest eine vordefinierte Resetfunktion der zu testenden Steuergeräte-Software ausgeführt wird.

Durch die zumindest eine Resetfunktion können nach dem Eintritt des Resetereignisses vorteilhaft frei definierte Funktionen innerhalb der Simulation ausgeführt werden. Vorzugsweise werden erst nach der Ausführung der Resetfunktionen innerhalb der Simulation die zur zu testenden Steuergeräte-Software gehörenden Daten gemäß dem vordefinierten Speicherabbild zurückgesetzt.

Dadurch können Funktionen der zu testenden Steuergeräte-Software innerhalb der Simulation (also als Teil der Simulation) ausgeführt werden, wie sie auch beim Einsatz der Steuergeräte-Software auf der Ziel-Hardware zum Einsatz kommen können, nachdem ein Resetereignis eingetreten ist.

Unter Resetfunktionen werden daher insbesondere solche Funktionen der zu testenden Steuergeräte-Software verstanden, die in Reaktion auf den Eintritt des Resetereignisses als Teil der Simulation ausgeführt werden.

Beispielsweise kann eine Resetfunktion der zu testenden Steuergeräte-Software aufweisen, dass innerhalb der Simulation ein Zugriff auf einen Speicherbereich und/oder eine Überprüfung eines Speicherbereiches jeweils der Ziel-Hardware der zu testenden Steuergeräte-Software durchgeführt wird. Die Ziel-Hardware kann dabei innerhalb der Simulation durch ein geeignetes Hardware-Modell der Ziel-Hardware simuliert werden (wobei das Hardware-Modell beispielsweise zumindest die Funktionalität des Speichers und/oder die notwendigen Schnittstellen zur Steuergeräte-Software innerhalb der Simulation simuliert).

Alternativ oder ergänzend kann auch vorgesehen sein, dass, nachdem die Resetfunktion als Teil der Simulation zumindest teilweise ausgeführt wurde, der erste Speicherbereich zumindest teilweise auf das vordefinierte Speicherabbild gesetzt wird.

Dadurch kann eine zeitliche Abfolge für die zu simulierenden Aspekte vorteilhaft vorgegeben werden.

Vorzugsweise wird, nachdem die Resetfunktion als Teil der Simulation vollständig ausgeführt wurde, der erste Speicherbereich auf das vordefinierte Speicherabbild gesetzt.

Alternativ oder ergänzend kann auch vorgesehen sein, dass während des Simulierens des Resetereignisses keine durch das Simulieren des Resetereignisses bedingte Unterbrechung der Verbindung zu anderen Simulationsteilnehmern erfolgt.

Dadurch wird zuverlässig erreicht, dass das simulierte Resetereignis als Ereignis innerhalb der Simulation und damit als Teil der Simulation stattfindet. Dadurch kann vorteilhaft und in besonders einfacher Weise auch ein Verhalten der entsprechenden Simulationsteilnehmer auf das Resetereignis einbezogen werden. Dies ermöglicht eine besonders realistische Simulation.

Alternativ oder ergänzend kann auch vorgesehen sein, dass, insbesondere innerhalb der Simulation, das virtuelle Steuergerät zumindest teilweise bereitgestellt wird durch einen ersten Softwareanteil, der die zu testende Steuergeräte-Software zumindest teilweise bereitstellt, und einen zweiten Softwareanteil, der ein Modell von zumindest Teilen der Ziel-Hardware zumindest teilweise bereitstellt.

Damit kann innerhalb der Simulation sehr vorteilhaft ein Verhalten der zu testenden Steuergeräte-Software in Bezug auf eine bestimmte Ziel-Hardware simuliert werden durch ein Zusammenspiel zwischen dem ersten und zweiten Softwareanteil.

Vorteilhaft wird durch den ersten und/oder zweiten Softwareanteil die Funktionalität zur Simulation des Resetereignisses, insbesondere zumindest teilweise oder vollständig, bereitgestellt. Damit können durch das vorgeschlagene Verfahren auch Simulationsplattformen ohne Bordmittel zur Simulation eines Resetereignisses auf einfache Weise zur Simulation eines Resetereignisses eingesetzt werden. Es kann dann nämlich genügen, dass der erste und/oder zweite Softwareanteil in der Simulationsplattform bereitgestellt werden können. Dadurch kann das vorgeschlagene Verfahren auch mit bestehenden Simulationsplattformen vorteilhaft ausführbar sein.

Vorzugsweise wird durch den ersten Softwareanteil und den zweiten Softwareanteil das virtuelle Steuergerät ganz oder teilweise ausgebildet, das in die Simulationsplattform geladen und ausgeführt werden kann.

Insbesondere ist es vorteilhaft möglich, dass durch den zweiten Softwareanteil innerhalb der Simulation eine Schnittstelle ausgebildet wird, durch welche die zu testende Steuergeräte-Software von der auszuführenden Plattform (sei es ein reales Steuergerät oder ein virtuelles Steuergerät) trennt.

Das virtuelle Steuergerät umfasst dabei vorteilhaft also die zu testende Steuergeräte-Software und darüber hinaus auch alle Funktionalitäten, die für eine Ausführung der zu testenden Steuergeräte-Software benötigt wird. Ein virtuelles Steuergerät, wie es auch für das vorliegende Verfahren verwendet werden kann, kann beispielsweise wie folgt erhalten werden: Zunächst wird die zu testende Steuergeräte-Software für eine Plattformen, auf der sie ausgeführt werden soll, übersetzt (das heißt kompiliert). Teile der zu testende Steuergeräte-Software, die nicht plattform-unabhängig sind, werden dabei ersetzt. Ein Steuergeräte-Software (sei es für reale oder virtuelle Steuergeräte) kann also insbesondere dadurch erhalten werden, dass plattform-unabhängige Softwarekomponenten (die der zu testenden Steuergeräte-Software entspricht) mit plattform-spezifischen Komponenten zusammengebracht werden. Die Schnittstelle ist bei den plattform-spezifischen Komponenten für reale und virtuelle Steuergeräte die Gleiche, die Implementierung jedoch unterschiedlich.

Beispielsweise kann der erste Softwareanteil in das virtuelle Steuergerät integriert sein und dadurch die zu testende Steuergeräte-Software innerhalb der Simulationsplattform und/oder für den Einsatz in der Simulation bereitgestellt und/oder ausgeführt werden.

Beispielsweise kann der zweite Softwareanteil in das virtuelle Steuergerät integriert sein und dadurch ein Modell der Ziel-Hardware oder Teilen davon innerhalb der Simulationsplattform und/oder für den Einsatz in der Simulation, insbesondere um ein Zusammenwirken mit der zu testenden Steuergeräte-Software innerhalb der Simulation zu ermöglichen, bereitgestellt werden.

Durch den zweiten Softwareanteil kann also mit anderen Worten die Ziel-Hardware (oder Teile davon) innerhalb der Simulation vorteilhaft simuliert werden. Damit können der zu testenden Steuergeräte-Software, auch ohne dass eine reale Hardware verfügbar sein muss, die notwendigen HardwareKomponenten und/oder -Funktionalitäten zur Laufzeit der Simulation innerhalb der Simulation bereitgestellt werden. Alternativ oder ergänzend können mit dem zweiten Softwareanteil auch an der Ziel-Hardware angeschlossene Sensoren simuliert werden.

Beispielsweise wird der erste Speicherbereich vermittelt durch den zweiten Softwareanteil auf das vordefinierte Speicherabbild gesetzt. Dadurch können vorteilhaft gerade solche Szenarien nachgebildet werden, in denen das Resetereignis nicht von der zu testenden Steuergeräte-Software ausgelöst, geschweige denn kontrolliert wird, und die zu testende Steuergeräte-Software zumindest teilweise daher darauf beschränkt ist, auf ein eingetretenes Resetereignis zu reagieren. Dies entspricht gewissen realen Szenarien besonders gut.

Vorzugsweise kooperieren die ersten und zweiten Softwareanteile innerhalb der Simulation derart, dass (aus Sicht der zu testenden Steuergeräte-Software) zumindest die für die Ausführung der zu testenden Steuergeräte-Software notwendigen Hardwarekomponenten und/oder Hardwareschnittstellen innerhalb der Simulation verfügbar sind. Dadurch kann zumindest gerade der Teil der Ziel-Hardware simuliert und zusammen mit der zu testenden Steuergeräte-Software innerhalb der Simulation zur Verfügung gestellt werden, der für die Ausführung der zu testenden Steuergeräte-Software in der Simulation notwendig ist. Mit anderen Worten und bildlich ausgedrückt, können also neben der zu testenden Steuergeräte-Software auch die Hardware-Anteile (jedenfalls im notwendigen Umfang) simuliert werden, derart, dass die zu testende Steuergeräte-Software während der Simulation "meint", sie würde auf der Ziel-Hardware ausgeführt werden. Insbesondere können dazu die Schnittstellen der zu testenden Steuergeräte-Software zum Hardware-abhängigen Teil der Steuergeräte-Software simuliert werden.

Alternativ oder ergänzend kann auch vorgesehen sein, dass das Simulieren des Resetereignisses aufweist, dass ein Verlauf der Simulation durch spezifische Einwirkungen beeinflusst wird, die auf ein Einbeziehen des ersten Softwareanteils und/oder auf ein Einbeziehen des zweiten Softwareanteils zurückzuführen sind, wobei vorzugsweise die spezifischen Einwirkungen, die auf das Einbeziehen des ersten Softwareanteils zurückzuführen sind, den Simulationsverlauf zumindest teilweise von innerhalb der Simulation beeinflussen und/oder die spezifischen Einwirkungen, die auf das Einbeziehen des zweiten Softwareanteils zurückzuführen sind, den Simulationsverlauf zumindest teilweise von außerhalb der Simulation beeinflussen.

Der Verlauf der Simulation kann beispielsweise durch die zu testende Steuergeräte-Software (und damit vorzugsweise von innerhalb der Simulation) beeinflusst werden, etwa durch ein Verhalten der zu testenden Software in Reaktion auf das Resetereignis. In diesem Fall kann die Beeinflussung auf spezifische Einwirkungen im Zusammenhang mit dem ersten Softwareanteil (das vorzugsweise die zu testende Steuergeräte-Software bereitstellt) zurückzuführen sein. Mit anderen Worten, kann die Beeinflussung gerade ein reguläres Verhalten der zu testenden Software auf das Resetereignis sein.

Der Verlauf der Simulation kann beispielsweise durch die simulierte Hardware beeinflusst werden, wobei insbesondere das Resetereignis selbst durch Maßnahmen simuliert wird, die die Simulationsdurchführung betreffen (und damit vorzugsweise von außerhalb der Simulation bewirkt werden). In diesem Fall kann die Beeinflussung auf spezifische Einwirkungen im Zusammenhang mit dem zweiten Softwareanteil (das vorzugsweise die virtuelle Hardware und/oder Schnittstellen zu der Hardware bereitstellt) zurückzuführen sein.

Das heißt, das Resetereignis kann in der Realität ein von der Ziel-Hardware "verursachtes" Ereignis mit bestimmten Auswirkungen auf die (reale) Steuergeräte-Software sein, die auf der jeweiligen Ziel-Hardware läuft. Im Rahmen der Simulation wird das Ereignis jedoch durch Herbeiführen einer simulativen Situation bewirkt, die die Auswirkungen des Ereignisses nachbildet.

Alternativ oder ergänzend kann auch vorgesehen sein, dass die spezifischen Einwirkungen, die auf das Einbeziehen des ersten Softwareanteils zurückzuführen sind, aufweisen, dass die vordefinierte Resetfunktion der zu testenden Steuergeräte-Software durch den ersten Softwareanteil bereitgestellt werden, und/oder die spezifischen Einwirkungen, die auf das Einbeziehen des zweiten Softwareanteils zurückzuführen sind, aufweisen, dass der erste Speicherbereich zumindest teilweise durch den zweiten Softwareanteil auf das vordefinierte Speicherabbild gesetzt wird.

Indem die Resetfunktion als Teil der Simulation ausgeführt wird, wirkt die Resetfunktion von innerhalb der Simulation. Indem der erste Speicherbereich außerhalb der Simulation auf das vordefinierte Speicherabbild gesetzt wird, wirkt diese Maßnahme, die zu einer Änderung der simulierten Steuergeräte-Software führen kann, von außerhalb der Simulation.

Alternativ oder ergänzend kann auch vorgesehen sein, dass das Simulieren des Resetereignisses aufweist, dass die spezifischen Einwirkungen, die auf das Einbeziehen des ersten Softwareanteils zurückzuführen sind, beendet oder unterbrochen werden und die spezifischen Einwirkungen, die auf das Einbeziehen des zweiten Softwareanteils zurückzuführen sind, begonnen oder fortgesetzt werden.

Dadurch kann das Durchführen der Simulation besonders vorteilhaft erfolgen. Die finale Simulation kann beispielsweise als durch mehrere Teil-Simulationen zusammengesetzt gedacht werden. So kann beispielsweise zunächst die Resetfunktion der zu testenden Steuergeräte-Software durch entsprechende Berechnungen auf der Host-Datenverarbeitungsvorrichtung im Rahmen der Simulation ausgeführt werden, wobei der erste Speicherbereich zu diesem Zeitpunkt bestehende Inhalte aufweist und damit das simulierte virtuelle Steuergerät (einschließlich der zu testenden Steuergeräte-Software) eine erste Konfiguration aufweisen kann. Dies führt zu einem ersten Teil einer Simulation. Anschließend wird der erste Speicherbereich neu gesetzt. Das simulierte virtuelle Steuergerät (einschließlich der zu testenden Steuergeräte-Software) kann dann eine zweite Konfiguration aufweisen. Sodann folgt eine weitere Berechnung der Simulation mit dem entsprechend geänderten virtuellen Steuergerät. Dies führt zu einem zweiten Teil einer Simulation. Die finale Simulation kann dann aus dem ersten und zweiten Teil (und ggf. weiteren Teilen) zusammengesetzt werden.

Alternativ oder ergänzend kann auch vorgesehen sein, dass die zu testende Steuergeräte-Software und der simulierte Teil der Ziel-Hardware innerhalb der Simulation jeweils zumindest eine nach AUTOSAR definierte Schnittstelle aufweisen, und die zu testende Steuergeräte-Software und der simulierte Teil der Ziel-Hardware über diese Schnittstelle innerhalb der Simulation datentechnisch miteinander gekoppelt sind, wobei vorzugsweise in Reaktion auf das Eintreten des Resetereignisses von dem simulierten Teil der Ziel-Hardware über die Schnittstelle ein Befehl zur Durchführung eines Resets an die zu testende Steuergeräte-Software gesendet wird.

Dadurch lässt sich sehr vorteilhaft eine Kompatibilität der zu testenden Steuergeräte-Software mit beispielsweise anderen Simulationsteilnehmern erreichen.

Alternativ oder ergänzend kann auch vorgesehen sein, dass das Speicherabbild des ersten Speicherbereichs zumindest teilweise durch den zweiten Softwareanteil angefertigt wird und/oder der erste Speicherbereich zumindest teilweise durch den zweiten Softwareanteil auf das vordefinierte Speicherabbild gesetzt wird.

Dadurch kann der zweite Softwareanteil zumindest einige der Maßnahmen übernehmen, die zur Simulation des durch die Ziel-Hardware verursachten Ereignisses notwendig sind. Damit kann gewissermaßen das, was mit der Hardware "zu tun hat", durch den zweiten Softwareanteil ganz oder teilweise bereitgestellt werden.

Alternativ oder ergänzend kann auch vorgesehen sein, dass der zweite Softwareanteil ferner zumindest einen der Simulation zugrunde liegenden Simulationscode und/oder zumindest einen Messdienst bereitstellt.

Vorzugsweise wird durch den Simulationscode zumindest teilweise das Simulationsszenario vorgegeben. Dadurch ist es sehr einfach und zuverlässig möglich, unterschiedliche Simulationsszenarien vorzugeben.

Der Messdienst kann beispielsweise eine Schnittstelle gemäß XCP (Universal Measurement and Calibration Protocol) bereitstellen.

Alternativ oder ergänzend kann auch vorgesehen sein, dass der erste Softwareanteil und der zweite Softwareanteil durch eine gemeinsame DLL-Datei bereitgestellt werden.

Das vorgeschlagene Verfahren ermöglicht es damit, das virtuelle Steuergerät mittels einer DLL-Datei bereitzustellen. Dadurch kann das virtuelle Steuergerät besonders einfach für einen Personal Computer kompiliert und in die jeweilige Simulationsplattform eingeladen werden.

DLL ist eine Abkürzung für "Dynamic Link Library" und bezeichnet allgemein eine dynamische Programmbibliothek. Vorliegend kann eine DLL-Datei durch einen Link-Vorgang erzeugt werden. Dabei wird der erste Softwareanteil und der zweite Softwareanteil gewissermaßen in einer gemeinsamen Einheit in Form der DLL-Datei vereinigt.

Dadurch ist es möglich, ein Resetereignis im Rahmen einer DLL-basierten SIL-Simulation zu simulieren, insbesondere ohne eine von der Simulationsplattform bereitgestellte Funktionalität zur Simulation eines Resetereignisses.

Insbesondere ist durch den Einsatz der DLL-Datei (insbesondere durch das Einladen der DLL-Datei in die Simulationsplattform) sichergestellt, dass der erste Softwareanteil und der zweite Softwareanteil einen gemeinsamen Speicherbereich (von dem der erste Speicherbereich zumindest ein Teil ist) der Speichereinheit der Host-Datenverarbeitungsanlage verwenden. Dadurch kann der zweite Softwareanteil den ersten Speicherbereich zuverlässig auf das vordefinierte Speicherabbild setzen. Vorzugsweise liegt der erste Softwareanteil und der zweite Softwareanteil jeweils als C-Code oder als Binary in Form von *.obj- oder *.lib-Dateien vor.

Auf diese Weise kann das virtuelle Steuergerät und/oder das Modell der Ziel-Hardware besonders einfach aber dennoch zuverlässig verteilt werden.

Beispielsweise kann die DLL-Datei durch einen Link-Vorgang erzeugt werden. Auf diese Weise kann das virtuelle Steuergerät auf einfache und zuverlässige Weise als eine Einheit bereitgestellt werden.

Indem die Funktionalität zur Simulation des Resetereignisses durch die DLL-Datei bereitgestellt wird, können auch Simulationsplattformen ohne Bordmittel zur Simulation eines Resetereignisses auf einfache Weise zur Simulation eines Resetereignisses eingesetzt werden. Dazu muss lediglich die zumindest eine DLL-Datei in die Simulationsplattform eingeladen werden können. Insbesondere muss damit das virtuelle Steuergerät nicht als "binary Image" bereitgestellt werden.

Vorteilhaft können mittels der zumindest einen DLL-Datei alle notwendigen Mittel innerhalb der Simulationsplattform bereitgestellt werden, um das Resetereignis zumindest teilweise zu simulieren.

Beispielsweise können durch einen Link-Vorgang der erste Softwareanteil und der zweite Softwareanteil innerhalb der DLL-Datei zusammengeführt werden.

Es ist dabei vorteilhaft, dass die zumindest eine DLL-Datei für die und/oder während der Simulation des Resetereignisses nicht entladen wird. Dadurch können etwaig bestehende Verbindungen zu anderen Simulationsteilnehmern während der Simulation des Resetereignisses bestehen bleiben.

Vorzugsweise wird das virtuelle Steuergerät unter dem Resetereignis in einer DLL-basierten SIL-Simulation und/oder mit einer standardisierten (zum Beispiel entsprechend dem FMI-Standard) Simulationsplattform simuliert. Dies kann besonders realitätsnah sein und ferner auch ohne, dass hierfür die jeweilige Simulationsplattform angepasst oder erweitert werden muss.

Alternativ oder ergänzend kann auch vorgesehen sein, dass die Simulation auf einer auf der Host-Datenverarbeitungsvorrichtung laufenden Simulationsplattform durchgeführt wird, und vorzugsweise die Durchführung der Simulation aufweist, dass die DLL-Datei in die Simulationsplattform und/oder in eine zumindest den ersten Speicherbereich aufweisende Speichereinheit der Host-Datenverarbeitungsvorrichtung geladen wird.

Durch die Möglichkeit, die DLL-Datei in die Simulationsplattform einzuladen, kann das Resetereignis auch mit herkömmlichen Simulationsplattformen vorteilhaft simuliert werden, ohne dass diese mit Bordmitteln das Simulieren eines Resetereignisses unterstützen müssen.

Vorteilhaft können mittels der DLL-Datei alle notwendigen Mittel innerhalb der Simulationsplattform bereitgestellt werden, um das Resetereignis zumindest teilweise zu simulieren.

Die Simulationsplattform kann beispielsweise in Software, in Hardware oder als eine Kombination aus beidem realisiert sein. Beispielsweise kann die Simulationsplattform eine auf der Host-Datenverarbeitungsvorrichtung ausführbare oder ausgeführte Software sein.

Alternativ oder ergänzend kann auch vorgesehen sein, dass durch die Simulation das Resetereignis simuliert wird und/oder dass durch die Simulation ein Verhalten des virtuellen Steuergerätes und/oder der zu testenden Steuergeräte-Software aufgrund des Resetereignisses simuliert wird.

Das Verhalten der zu testenden Steuergeräte-Software ist insbesondere ein Verhalten zumindest teilweise in Reaktion auf das Setzen des ersten Speicherbereichs auf das vordefinierte Speicherabbild.

Alternativ oder ergänzend kann auch vorgesehen sein, dass in einem zweiten Speicherbereich der Host-Datenverarbeitungsvorrichtung, insbesondere ausschließlich, zweite Informationen gespeichert werden, die Konfigurationsinformationen der Simulationsplattform und/oder Zustandsvariablen der Simulation als solches darstellen.

Auf diese Weise kann besonders einfach eine Trennung zwischen Informationen, durch die das virtuelle Steuergerät (und insbesondere die zu testende Steuergeräte-Software) innerhalb der Simulation definiert wird, und Informationen, die die Simulation als solches definieren (beispielsweise eine Simulationszeit, eine Simulations-Schrittweite, etc.), erreicht werden. Somit kann durch eine Manipulation des ersten Speicherbereichs zuverlässig und sicher gezielt die zu testende Steuergeräte-Software und letztlich den Simulationsverlauf beeinflusst werden.

Alternativ oder ergänzend kann auch vorgesehen sein, dass die Ziel-Hardware der zu testenden Steuergeräte-Software ein elektronisches Steuergerät ist und/oder die Ziel-Hardware der zu testenden Steuergeräte-Software zur Host-Datenverarbeitungsvorrichtung verschieden ist.

Das elektronische Steuergerät kann beispielsweise ein elektronisches Steuergerät für ein Kraftfahrzeug sein. Gerade im Bereich der Entwicklung von elektronischen Steuergeräten, und vor allem solche für Kraftfahrzeuge, ist die vorgeschlagene Simulation besonders vorteilhaft.

Alternativ oder ergänzend kann auch vorgesehen sein, dass die Host-Datenverarbeitungsvorrichtung ein Personal Computer ist.

Dies ist besonders vorteilhaft, da dadurch die Simulation auch mit vergleichsweise geringen Ressourcen durchführbar sein kann.

Anstelle eines Personal Computers ist es aber in Ausführungsformen auch möglich, dass die Host-Datenverarbeitungsvorrichtung ein verteiltes Rechner-System aufweist oder darstellt. Dadurch können entsprechende Ressourcen beispielsweise geografisch verteilt bereitgehalten und zur Verfügung gestellt werden. Auch können somit Ressourcen nach Bedarf leicht erweitert werden, um beispielsweise bei rechenintensiven Simulationen zusätzliche Rechenleistung nutzen zu können.

Die Aufgabe wird durch die Erfindung gemäß einem **zweiten Aspekt** dadurch gelöst, dass eine Vorrichtung zur Datenverarbeitung zum Durchführen einer SIL-Simulation, die Vorrichtung aufweisend Mittel, die dazu eingerichtet sind, ein Verfahren gemäß dem ersten Aspekt der Erfindung auszuführen, vorgeschlagen wird.

Alle Vorteile, die in Bezug auf das Verfahren gemäß dem ersten Aspekt der Erfindung beschrieben wurden, gelten dabei entsprechend auch für die Vorrichtung gemäß dem zweiten Aspekt der Erfindung. Daher kann insoweit an dieser Stelle auf die vorherigen Ausführungen verwiesen werden.

Die Merkmale, die in Bezug auf das Verfahren gemäß dem ersten Aspekt der Erfindung beschrieben wurden, können dabei auch bei der Vorrichtung entsprechend vorgesehen sein, einzeln und in beliebiger Kombination, sofern sich aus dem Zusammenhang nichts anderes ergibt.

Die Vorrichtung zur Datenverarbeitung weist vorzugsweise zumindest einen Prozessor und/oder zumindest eine Speichereinheit auf, in der der in Bezug auf den ersten Aspekt der Erfindung beschriebene erste Speicherbereich und/oder zweite Speicherbereich vorgesehen ist bzw. sind.

Die Vorrichtung zur Datenverarbeitung kann beispielsweise die in Bezug auf den ersten Aspekt der Erfindung beschriebene Host-Datenverarbeitungsvorrichtung aufweisen oder darstellen.

Die Aufgabe wird durch die Erfindung gemäß einem **dritten Aspekt** dadurch gelöst, dass ein Computerprogrammprodukt, umfassend Befehle, die bei der Ausführung des Programms durch eine Vorrichtung zur Datenverarbeitung, insbesondere die Vorrichtung zur Datenverarbeitung gemäß dem zweiten Aspekt der Erfindung, diese veranlassen, ein Verfahren gemäß dem ersten Aspekt der Erfindung auszuführen, vorgeschlagen wird.

Die Aufgabe wird durch die Erfindung gemäß einem **vierten Aspekt** dadurch gelöst, dass eine Signalfolge, die insbesondere über ein Computernetzwerk übermittelbar ist, wobei die Signalfolge Daten zumindest einer DLL-Datei repräsentiert, welche DLL-Datei in einem Verfahren gemäß dem ersten Aspekt der Erfindung verwendbar ist, vorgeschlagen wird.

Durch die Signalfolge können vorteilhaft alle notwendigen Mittel, um das Resetereignis zumindest teilweise zu simulieren, zwischen verschiedenen Teilnehmern ausgetauscht werden.

Beispielsweise kann die Signalfolge von einem entfernten Rechner empfangbar sein.

Die Aufgabe wird durch die Erfindung gemäß einem **fünften Aspekt** dadurch gelöst, dass eine Simulationsplattform, die dazu eingerichtet ist, zumindest eine entweder im Zusammenhang mit dem ersten Aspekt der Erfindung beschriebene und/oder durch eine Signalfolge gemäß dem vierten Aspekt der Erfindung übertragbare DLL-Datei einzuladen, vorgeschlagen wird.

Auf diese Weise kann eine Simulationsplattform besonders vorteilhaft dazu eingesetzt werden, ein virtuelles Steuergerät unter einem Resetereignis zu simulieren.

Beispielsweise kann die Simulationsplattform eine PC-basierte Simulationsplattform sein, die SIL-Tests bei der Entwicklung elektronischer Steuergeräte unterstützt. Dazu kann die Simulationspattform vorteilhaft das Simulieren einer Vielzahl unterschiedlicher Modelle, darunter etwa Funktionsmodelle, Functional Mock-up Units (FMUs), virtuelle Steuergeräte und Fahrzeugmodelle, sowie auch Netzwerke virtueller Steuergeräte und Bussysteme unabhängig von jeglicher Simulationshardware, insbesondere auch in frühen Phasen der Entwicklung, ermöglichen und vorzugsweise dazu entsprechend eingerichtet zu sein. In Szenarien mit mehreren Modellen kann die Simulationsplattform vorteilhaft Import, Anschluss und Ausführung von (insbesondere beliebig vieler) Funktions- und Streckenmodelle basierend auf einer Modellierungs-Software und/oder Functional Mock-up Interface (FMI) ermöglichen und vorzugsweise dazu entsprechend eingerichtet sein.

Vorteilhafterweise ist die Simulationsplattform nach dem FMI-Standard standardisiert.

Alle Vorteile und Merkmale, die in Bezug auf das Verfahren gemäß dem ersten Aspekt der Erfindung beschrieben wurden, gelten dabei entsprechend auch für das Computerprogrammprodukt gemäß dem dritten Aspekt der Erfindung, für die Signalfolge gemäß dem vierten Aspekt der Erfindung und für die Simulationsplattform gemäß dem fünften Aspekt der Erfindung, sofern sich jeweils aus dem Zusammenhang nichts anderes ergibt. Daher kann insoweit auf die vorherigen Ausführungen verwiesen werden.

### Kurze Beschreibung der Zeichnungen

Weitere Merkmale und Vorteile der Erfindung ergeben sich aus der nachfolgenden Beschreibung, in der bevorzugte Ausführungsformen der Erfindung anhand schematischer Zeichnungen erläutert werden.

Dabei zeigen:
- Fig. 1: eine schematische Darstellung einer Vorrichtung zur Datenverarbeitung gemäß dem zweiten Aspekt der Erfindung;
- Fig. 2: eine schematische Darstellung einer Speichereinheit der Vorrichtung zur Datenverarbeitung der Fig. 1;
- Fig. 3: ein Blockschaltbild einer Simulationsplattform gemäß dem fünften Aspekt der Erfindung; und
- Fig. 4: einen Ablaufplan eines Verfahrens gemäß dem ersten Aspekt der Erfindung.

### Beschreibung der Ausführungsformen

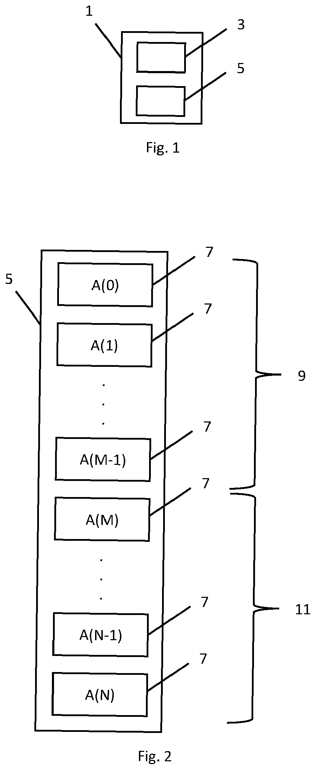

**Fig. 1** zeigt eine schematische Darstellung einer Vorrichtung zur Datenverarbeitung 1 gemäß dem zweiten Aspekt der Erfindung.

Die Vorrichtung zur Datenverarbeitung 1 weist einen Prozessor 3 (beispielsweise einen X86-Prozessor) und eine Speichereinheit 5 auf. Die Vorrichtung zur Datenverarbeitung 1 kann außerdem noch weitere, in Fig. 1 jedoch nicht dargestellte Komponenten, wie Eingabeeinheiten, Ausgabeeinheiten, Schnittstellen, etc., aufweisen. Vorzugsweise ist die Vorrichtung zur Datenverarbeitung 1 ein Personal Computer.

**Fig. 2** zeigt eine schematische Darstellung der Speichereinheit 5.

Die Speichereinheit 5 weist eine Vielzahl von N Speicherzellen 7 auf. Jede Speicherzelle 7 kann über eine Speicheradresse A(...) angesprochen werden, um auf den Inhalt der jeweiligen Speicherzelle 7 lesend zuzugreifen und/oder um einen Inhalt in die jeweilige Speicherzelle 7 zu schreiben. Die Speichereinheit 5 kann ein RAM-Speicher (Arbeitsspeicher) der Vorrichtung zur Datenverarbeitung 1 sein. Beispielsweise stellen die M Speicherzellen 7 mit den Adressen A(0) bis A(M-1) einen ersten Speicherbereich 9 der Speichereinheit 5 dar und/oder die N-M+1 Speicherzellen 7 mit den Adressen A(M) bis A(N) stellen einen zweiten Speicherbereich 11 der Speichereinheit 5 dar. In anderen Ausführungsformen kann die Speichereinheit 5 weitere Speicherzellen aufweisen, die nicht notwendig dem ersten Speicherbereich 9 und dem zweiten Speicherbereich 11 zugeordnet sind. In noch anderen Ausführungsformen kann sich die Speichereinheit 5 aus mehreren Sub-Speichereinheiten aufbauen, die räumlich auch verteilt sein können.

Die Vorrichtung zur Datenverarbeitung 1 kann zur Durchführung einer SIL-Simulation einer Software eingesetzt werden, die auf einem elektronischen Steuergerät (ECU) ausgeführt werden soll. Diese Software ist mithin eine Steuergeräte-Software und wird im Zusammenhang mit der Simulation als die zu testende Steuergeräte-Software bezeichnet. Die zu testende Steuergeräte-Software kann dabei aus der vollständigen Software, wie sie später auf dem elektronischen Steuergerät ausgeführt werden soll, bestehen. Die zu testende Steuergeräte-Software kann aber auch nur aus einem Teil der vollständigen Software bestehen. Auf diese Weise können auch einzelne Teile der Software für sich und auf unterschiedlichen Entwicklungsstufen simuliert werden. Dies ermöglicht es, dass einzelne Softwareteile parallel entwickelt und getestet werden können und die einzelnen Teile erst zu einem späteren Zeitpunkt zusammengeführt werden. Ein weiterer Vorteil der SIL-Simulation ist es, dass die Tests unabhängig von der Ziel-Hardware durchgeführt werden können. Die Ziel-Hardware ist diejenige Hardware, auf der die zu testende Steuergeräte-Software später ausgeführt werden soll. Die Ziel-Hardware kann einen Mikrocontroller aufweisen oder darstellen. Aufgrund der besagten Unabhängigkeit kann die Softwareentwicklung auch parallel zur Hardwareentwicklung erfolgen. SIL-Simulationen bieten damit eine effiziente Möglichkeit, Software für elektronische Steuergeräte während deren Entwicklungsprozess fortlaufend zu validieren.

Eine auf einem (realen) elektronischen Steuergerät ausgeführte Software wechselwirkt mit der jeweiligen Hardware des elektronischen Steuergeräts auf vielfältige Weise. Beispielsweise kann die Software über physische Schnittstellen des elektronischen Steuergerätes Daten senden und/oder empfangen. Über diese Schnittstellen kann das elektronische Steuergerät etwa an ein oder mehrere Bus-Systeme angebunden sein und drüber mit anderen Bus-Teilnehmern Daten austauschen. Die anderen Bus-Teilnehmer können beispielsweise Sensoren sein, die Umgebungsdaten (im Fall eines elektronischen Steuergerätes für Kraftfahrzeuge können dies zum Beispiel eine Fahrzeuggeschwindigkeit, eine Motortemperatur, ein Motordrehmoment, etc. sein) erfassen und diese dem elektronischen Steuergerät bereitstellen. Das elektronische Steuergerät kann diese Daten dann bei der Steuerung und/oder Regelung einer Steuer- und/oder Regelgröße einsetzen. Die Hardware des elektronischen Steuergerätes kann auch direkt mit anderen Systemen datentechnisch gekoppelt sein und beispielsweise ein Regel- und/oder Steuersignal an diese senden. Ein Beispiel für ein elektronisches Steuergerät im Fahrzeugbereich ist ein elektronisches Steuergerät für einen Motor eines Kraftfahrzeugs, das dann auch als Motorsteuergerät bezeichnet wird.

Da die Ziel-Hardware bei der SIL-Simulation auf der Vorrichtung zur Datenverarbeitung 1 nicht vorhanden ist, werden die im Produktiveinsatz von der Ziel-Hardware bereitgestellten Funktionen, zumindest soweit diese während der Simulation für die zu testende Steuergeräte-Software erforderlich sind, ebenfalls simuliert. Hierzu kann ein Hardware-Modell eingesetzt werden, das die notwendigen Funktionen für die Simulation bereitstellt (beispielsweise der Empfang von Sensordaten). Das Modell kann damit als eine Abstraktion der Ziel-Hardware verstanden werden, das die für die Simulation der zu testenden Software erforderliche Hardware-Funktionalität in der Simulation bereitstellt. Darüber hinaus wird auch die zu testende Steuergeräte-Software in der Simulation bereitgestellt. Beides zusammen, die Hardware-Abstraktion und die zu testende Steuergeräte-Software, bildet das für die Simulation eingesetzte virtuelle Steuergerät. Das virtuelle Steuergerät kann also, mit anderen Worten ausgedrückt, als die zu testende Steuergeräte-Software zusammen mit all dem, was für die Ausführung der zu testenden Steuergeräte-Software benötigt wird, verstanden werden. Wünschenswert ist es, dass mit einer solchen SIL-Simulation das virtuelle Steuergerät auch unter dem Einfluss eines Resetereignisses simuliert werden kann. Beispielsweise kann das Resetereignis ein Reset eines Mikrokontrollers, den die Ziel-Hardware aufweist oder aus dem die Ziel-Hardware besteht, sein.

Zur Durchführung einer entsprechenden SIL-Simulation auf der als eine Host-Datenverarbeitungsvorrichtung fungierenden Vorrichtung zur Datenverarbeitung 1 kann eine Simulationsplattform eingesetzt werden.

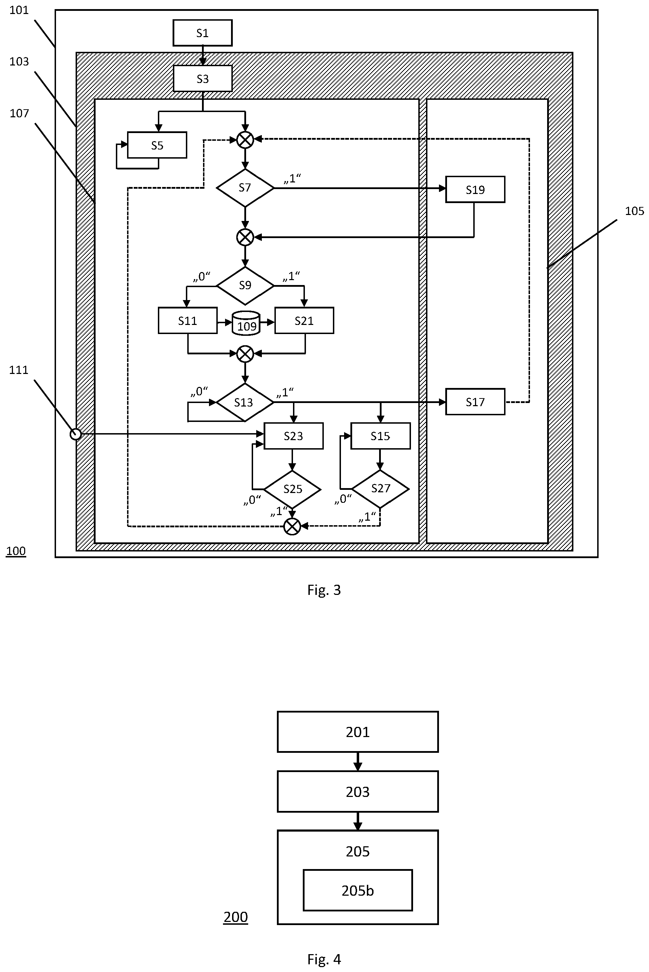

Fig. 3 zeigt ein Blockschaltbild 100 einer Simulationsplattform 101 gemäß dem fünften Aspekt der Erfindung. Bei Entscheidungsblöcken des Blockschaltbilds 100, ausgehend von denen mehrere Optionen (Pfade) alternativ möglich sind, ist der Pfad, der bei einem positiven Ergebnis ("Ja") verfolgt wird mit "1" und der Pfad, der bei einem negativen Ergebnis ("ein") verfolgt wird mit "0" gekennzeichnet.

Die Simulationsplattform 101 stellt auf der Vorrichtung zur Datenverarbeitung 1 eine Simulationsumgebung bereit. In diese kann eine DLL-Datei 103 eingeladen werden. Die DLL-Datei kann dafür beispielswiese mittels einer Signalfolge gemäß dem vierten Aspekt der Erfindung, etwa von einem Datenträger und/oder über ein Computernetzwerk, empfangen worden sein. Zur besseren Orientierung ist in dem Blockschaltbild 100 der Block 103 der DLL-Datei schraffiert dargestellt. Die eingeladene DLL-Datei 103 stellt in der Simulationsplattform 101, und speziell innerhalb der Simulationsumgebung, einen ersten Softwareanteil 105 und einen zweiten Softwareanteil 107 bereit. Mit dem ersten Softwareanteil 105 wird die zu testende Steuergeräte-Software innerhalb der Simulationsplattform 101 und damit innerhalb der Simulationsumgebung verfügbar gemacht. Mit dem zweiten Softwareanteil 107 wird ein Modell der jeweiligen Ziel-Hardware innerhalb der Simulationsplattform 101 und damit innerhalb der Simulationsumgebung verfügbar gemacht. Durch beide Softwareanteile 105 und 107 wird das virtuelle Steuergerät innerhalb der Simulationsplattform 101 und damit innerhalb der Simulationsumgebung verfügbar gemacht. Die DLL-Datei kann dazu zuvor beispielsweise mittels eines Link-Vorgangs aus den beiden (insbesondere zunächst einzeln vorliegenden) Softwareanteilen 105, 107 erzeugt werden und damit beide Softwareanteile 105, 107 in der DLL-Datei vereinen.

In einem Block S1 wird die DLL-Datei in die Simulationsplattform eingeladen. Hierzu kann die DLL-Datei 103 beispielsweise in einen Speicher der Vorrichtung zur Datenverarbeitung 1 eingeladen werden.

Sodann werden in einem Block S3 die Variablen der SIL-Simulation initialisiert. Dabei können zum Beispiel alle globalen Variablen der Simulation durch einen Startup-Code eines Compilers der Simulationsplattform 101 initialisiert werden. Auch das Initialisieren der Variablen der zu testenden Steuergeräte-Software und des Modells der Ziel-Hardware, also die des ersten und zweiten Softwareanteils 105 und 107, kann dabei ausgeführt werden. In dem ersten Speicherbereich 9 können beispielsweise die Variablen der zu testenden Steuergeräte-Software abgelegt werden. Dadurch sind vorzugsweise alle Konfigurationsinformationen der zu testenden Steuergeräte-Software in dem ersten Speicherbereich 9 gespeichert. In dem zweiten Speicherbereich 11 können beispielsweise die Variablen der Simulationsplattform 101 abgelegt werden. Dadurch sind vorzugsweise alle Konfigurationsinformationen der Simulationsplattform (einschließlich etwaige Simulationsparameter, wie deren Schrittweite, Simulationsdauer, etc.) in dem zweiten Speicherbereich 11 gespeichert.

Anschließend können in einem Block S5 verschiedene Dienste und/oder Funktionen der Ziel-Hardware vermittelt durch den zweiten Softwareanteil 107 ausgeführt werden. Beispiele hierfür sind Messdiente (etwa XCP) und dergleichen. Außerdem wird in einem Block S7 geprüft, ob ein Reset angefordert wurde. Wenn dies, wie insbesondere nach einem Start der Simulationsplattform 101, nicht der Fall ist, wird in einem Block S9 geprüft, ob ein Speicherabbild des ersten Speicherbereichs 9 der Vorrichtung zur Datenverarbeitung 1 (also der Host-Datenverarbeitungsvorrichtung) besteht. Wenn ein solches Speicherabbild, wie insbesondere nach einem Neu- oder Erst-Start der Simulationsplattform 101, nicht existiert, wird in einem Block S11 ein Speicherabbild 109 des ersten Speicherbereichs 9 der Speichereinheit 5 angefertigt und in einem Speicher (beispielsweise in einem anderen Speicherbereich als den ersten und zweiten Speicherbereich 9, 11 der Speichereinheit 5) der Vorrichtung zur Datenverarbeitung 1 zwischengespeichert. In dem Speicherabbild 109 sind also gerade die Konfigurationsinformationen der zu testenden Steuergeräte-Software zu einem bestimmten Zeitpunkt nach der Erstinitialisierung, insbesondere unmittelbar nach der Erstinitialisierung, gesichert. Anschließend wird in einem Block S13 auf den Start der SIL-Simulation gewartet.

Mit dem Start der SIL-Simulation wird in einem Block S15 die Ziel-Hardware im für die Simulation der zu testenden Steuergeräte-Software notwendigen Umfang emuliert. Dadurch werden beispielsweise Funktionalitäten, die typischerweise von der Ziel-Hardware bereitgestellt werden, in der Simulation verfügbar gemacht. Außerdem werden mit dem Start der SIL-Simulation in einem Block S17 Funktionen der zu testenden Steuergeräte-Software ausgeführt. In der Gesamtschau wird damit also das virtuelle Steuergerät simuliert. Dies erfolgt dabei nach einem durch ein Simulationsszenario vorab festgelegten Weise. Beispielsweise kann das Simulationsszenario eine Fahrt mit einem Kraftfahrzeug durch eine Innenstadt darstellen. Hierzu können dann der zu testenden Steuergeräte-Software alle für dessen Test notwendigen Eingangsgrößen (wie Sensordaten, etc.) virtuell bereitgestellt werden. Für die zu testende Steuergeräte-Software "sieht" dies innerhalb der Simulation dann mit anderen Worten so aus, als würde das Kraftfahrzeug durch die Innenstadt fahren.

Ein Teil des Simulationsszenarios kann auch ein Resetereignis sein. Beispielsweise kann bei einem realen Steuergerät ein Software-Reset zum Neueinlesen der Variablenwerte der Variablen der Steuergeräte-Software erfolgen. Wenn ein solches Resetereignis (dies kann auch als "Software-Reset" bezeichnet werden) als Teil des Simulationsszenarios simuliert werden soll, verlässt die Simulation den Block S17 und gelangt wieder zu dem Block S7. Beispielsweise kann die zu testende Steuergeräte-Software innerhalb der Simulation dazu eine durch die simulierte Ziel-Hardware ausgebildete Schnittstelle ansprechen, woraufhin der weitere Verlauf des Resetereignisses stattfindet, der dann jedoch im Vergleich zu einem realen Steuergerät simulationsspezifisch behandelt wird. Dies ist in dem Blockschaltbild 100 durch einen gestrichelten Pfeil illustriert, der von dem Block S17 wegführt. Der Block S7 definiert also gewissermaßen eine Rücksprungmarke, zu der gesprungen wird, wenn gemäß dem Simulationsszenario das Resetereignis eintritt. Da nun ein Reset angefordert wurde, wird daraufhin in Block S19 eine oder mehrere Resetfunktionen der zu testenden Steuergeräte-Software ausgeführt. Dies kann beispielsweise bei realen Steuergeräten eine Prüfung eines Speicherbereichs des Speichers der Hardware sein. Nachdem die Resetfunktionen ausgeführt wurden, wird in dem Block S9 geprüft, ob ein Speicherabbild des ersten Speicherbereichs 9 der Vorrichtung zur Datenverarbeitung 1 besteht. Wenn ein solches Speicherabbild, wie insbesondere nach dem Start der Simulation, existiert, wird in einem Block S21 der erste Speicherbereich 9 auf das in dem Speicher abgelegten und damit vordefinierten Speicherabbild 109 gesetzt. Dadurch werden seit der durchgeführten Sicherung geänderte Inhalte des ersten Speicherbereichs 9 überschrieben. Dadurch werden also die Konfigurationsinformationen der zu testenden Steuergeräte-Software auf die zum Zeitpunkt der Sicherung in Block S11 bestehenden Werte nach der Erstinitialisierung gesetzt. Insbesondere die Werte der Simulationsplattform 101 werden dadurch, da sich diese in dem zweiten Speicherbereich 11 befinden, aber nicht geändert. Anschließend wird in dem Block S13 auf den Start bzw. das Fortsetzen der SIL-Simulation gewartet und sodann in dem Block S15 wieder Funktionalitäten der Ziel-Hardware simuliert und in dem Block S17 Funktionen der zu testenden Steuergeräte-Software ausgeführt.

Da damit die Simulation des virtuellen Steuergerätes mit den Werten gemäß dem zurückgespielten Speicherabbild 109 fortgesetzt wird, wirkt die vermittelt durch den zweiten Softwareanteil 107 von außerhalb der Simulation vorgenommene Maßnahme der Rücksicherung des Speicherabbildes 109 in den ersten Speicherbereich 9 innerhalb der Simulation derart, als wäre bei der zu testenden Steuergeräte-Software ein Reset durchgeführt worden.

Anhand des Blockschaltbildes 100 ist ersichtlich, wie das Resetereignis und das anschließende Verhalten der zu testenden Steuergeräte-Software innerhalb der Simulation durch ein Wechselspiel zwischen dem ersten Softwareanteil 105 und dem zweiten Softwareanteil 107 simuliert wird. Es tragen also mit anderen Worten beide Softwareanteile 105 und 107 zur Simulation des Resetereignisses bei. Dabei erfolgt durch das Einbeziehen des ersten Softwareanteils 105 eine Beeinflussung des Simulationsverlaufs von innerhalb der Simulation (insbesondere durch die ausgeführten Resetefunktionen in Block S19) und durch das Einbeziehen des zweiten Softwareanteils 107 eine Beeinflussung des Simulationsverlaufs von außerhalb der Simulation (insbesondere durch das Neusetzen des ersten Speicherbereichs 9 in Block S21).

Ein Teil des Simulationsszenarios kann alternativ oder ergänzend auch ein Resetereignis sein, das von extern ausgelöst wird. Bei realen Steuergeräten kann ein von extern ausgelöstes Reset-Ereignis beispielsweise im Rahmen einer Überwachung eines Steuergerätes durch ein weiteres Steuergerät auftreten. Stellt das überwachende weitere Steuergerät ein Fehlverhalten bei dem zu überwachenden Steuergerät fest, so kann das überwachende weitere Steuergerät durch ein externes Reset-Signal das überwachte Steuergerät zurücksetzen. Dies ist ein Fall eines Resetereignisses, das auch als Hardware-Reset bezeichnet wird. Zur Simulation eines solchen Resetereignisses wird in Ausführungsformen nach dem Start der Simulation in einem Block S23 eine Erkennung einer externen Reset-Anforderung gestartet. Über einen VPU-Port 111 kann ein Reset-Signal eingelesen werden. Wenn in Block S25 eine Anfrage eines externen Resets erkannt wird und daher ein solches Resetereignis als Teil des Simulationsszenarios simuliert werden soll, gelangt die Simulation wieder zu dem Block S7. Dies ist in dem Blockschaltbild 100 durch einen gestrichelten Pfeil illustriert, der von dem Block S25 (bzw. dem nachfolgenden Knotenpunkt) wegführt. Der Block S7 ist also auch in diesem Fall wieder gewissermaßen eine Rücksprungmarke, zu der gesprungen wird, wenn gemäß dem Simulationsszenario das Resetereignis eintritt. Die weiteren Schritte der Simulation des Resetereignisses sind ganz vergleichbar wie zuvor beschrieben, so dass auf die vorherigen Ausführungen verwiesen werden kann.

Ein Teil des Simulationsszenarios kann alternativ oder ergänzend auch ein Resetereignis sein, das einen Hardware-Reset aufweist, der durch die simulierte Hardware-Funktionalität (also die Emulation von Teilen der Ziel-Hardware in Form einer Microcontroller-Hardware) ausgelöst wird. Beispielsweise kann ein solcher Reset bei realen Steuergeräten durch eine sogenannte Watchdog-Hardware ausgelöst werden, wenn die Steuergeräte-Software des Steuergerätes durch ein Fehlverhalten den "Watchdog" nicht in regelmäßigen Abständen zurücksetzt. Im Rahmen der Simulation kann dazu in Ausführungsformen in einem Block S27 ein solcher Hardware-Reset erkannt und als Teil des Simulationsszenarios simuliert werden. Wenn in Reaktion auf ein Watchdog-Ereignis ein Reset der Hardware des elektronischen Steuergerätes erfolgen soll kann dies in der Simulation dadurch simuliert werden, dass, nachdem ein solches Resetereignis erkannt wird, die Simulation wieder zu dem Block S7 gelangt. Die weiteren Schritte der Simulation des Resetereignisses sind auch hier wieder ganz vergleichbar wie zuvor beschrieben, so dass auf die vorherigen Ausführungen verwiesen werden kann.

Das Blockschaltbild 100 illustriert also vorteilhaft ein Resetereignis einer DLL-basierten SIL-Simulation eines virtuellen Steuergerätes. Dadurch kann ein virtuelles Steuergerät (und insbesondere die zu testende Steuergeräte-Software) unter einem Resetereignis in einer DLL-basierten SIL-Simulation realitätsnah simuliert werden, ohne dass hierfür die Simulationsplattform 101 angepasst oder erweitert werden muss.

**Fig.** 4 zeigt einen Ablaufplan eines Verfahrens 200 gemäß dem ersten Aspekt der Erfindung.

In 201 wird eine Host-Datenverarbeitungsvorrichtung mit einer darauf verfügbaren Simulationsplattform zur Durchführung einer SIL-Simulation eines virtuellen Steuergerätes bereitgestellt. Die Simulationsplattform kann wie die in Bezug auf das Blockschaltbild der Fig. 3 beschriebene Simulationsplattform 101 ausgebildet sein.

In 203 wird eine zu testende Steuergeräte-Software und ein Modell einer Ziel-Hardware der zu testenden Steuergeräte-Software in der Simulationsplattform bereitgestellt. Dies erfolgt beispielsweise dadurch, dass eine DLL-Datei in die Simulationsplattform eingeladen wird. Die zu testende steuergeräte-Software und das Modell der Ziel-Hardware stellen zusammen das virtuelle Steuergerät dar.

In 205 wird mit der Simulationsplattform das virtuelle Steuergerät innerhalb eines Simulationsszenarios simuliert. Das Simulationsszenario weist dabei einen Eintritt eines Resetereignisses auf. Um das Resetereignis zu simulieren, wird in 205b zumindest ein erster Speicherbereich einer Speichereinheit der Host-Datenverarbeitungsvorrichtung zumindest teilweise auf ein vordefiniertes Speicherabbild gesetzt.

Die in der vorangehenden Beschreibung, in den Zeichnungen und in den Ansprüchen offenbarten Merkmale können sowohl einzeln als auch in beliebiger Kombination wesentlich für die Erfindung in ihren verschiedenen Ausführungsformen sein.

### Bezugszeichenliste

- 1: Vorrichtung zur Datenverarbeitung
- 3: Prozessor
- 5: Speichereinheit
- 7: Speicherzelle
- 9: Erster Speicherbereich
- 11: Zweiter Speicherbereich
- 100: Blockschaltbild
- 101: Simulationsplattform
- 103: DLL-Datei
- 105: Erster Softwareanteil
- 107: Zweiter Softwareanteil
- 109: Speicherabbild
- 111: VPU-Port
- 200: Ablaufplan
- 201: Bereitstellen einer auf einer Host-Datenverarbeitungsvorrichtung laufenden Simulationsplattform zur Durchführung einer SIL-Simulation eines virtuellen Steuergerätes
- 203: Bereitstellen einer zu testenden Steuergeräte-Software und eines Modells der Ziel-Hardware, die zusammen das virtuelle Steuergerät darstellen
- 205: Simulieren des virtuellen Steuergeräts innerhalb eines Simulationsszenarios
- 205b: Simulieren eines Resetereignisses als Teil des Simulationsszenarios indem ein erster Speicherbereich der Host-Datenverarbeitungsvorrichtung zumindest teilweise auf ein vordefiniertes Speicherabbild gesetzt wird
- A(...): Adresse einer Speicherzelle
- S1: Einladen einer DLL-Datei in die Simulationsplattform
- S3: Initialisieren der Variablen der SIL-Simulation
- S5: Ausführen von Diensten und/oder Funktionen der Ziel-Hardware
- S7: Wurde ein Reset angefordert?
- S9: Existiert ein Speicherabbild?
- S11: Anfertigen Speicherabbild des ersten Speicherbereichs
- S13: Start/Fortsetzen der Simulation?
- S15: Simulieren von Funktionalitäten der Ziel-Hardware
- S17: Ausführen von Funktionen des virtuellen Steuergerätes
- S19: Ausführen von Resetfunktionen des virtuellen Steuergerätes
- S21: Setzen des ersten Speicherbereichs auf das Speicherabbild
- S23: Starten einer Erkennung von externen Reset-Anfragen
- S25: Wurde ein Reset von extern angefordert?
- S27: Wurde ein Hardware-Reset angefordert?
- "0": Negatives Ergebnis/Nein
- "1": Positives Ergebnis/Ja

## Patentansprüche

1. Verfahren zur Durchführung einer auf einer Host-Datenverarbeitungsvorrichtung (1) laufenden SIL-Simulation, wobei durch die Simulation ein virtuelles Steuergerät innerhalb eines Simulationsszenarios simuliert wird, wobei das Simulationsszenario ein Eintritt eines Resetereignisses aufweist, und wobei das Simulieren des Resetereignisses aufweist, dass zumindest ein erster Speicherbereich (9) zumindest einer Speichereinheit (5) der Host-Datenverarbeitungsvorrichtung (1) zumindest teilweise auf ein vordefiniertes Speicherabbild (109) gesetzt wird.

2. Verfahren nach Anspruch 1, wobei in dem ersten Speicherbereich (9), insbesondere ausschließlich, erste Informationen gespeichert werden, die vorzugsweise Konfigurationsinformationen einer zu testenden Steuergeräte-Software, die Teil des virtuellen Steuergerätes ist, innerhalb der Simulation darstellen, wobei vorzugsweise die ersten Informationen Variablenwerte von Variablen der zu testenden Steuergeräte-Software innerhalb der Simulation sind.

3. Verfahren nach einem der vorangehenden Ansprüche, wobei durch das Resetereignis des Simulationsszenarios ein, insbesondere in Reaktion auf ein Watchdog-Ereignis durchgeführter, Reset einer Ziel-Hardware der zu testenden Steuergeräte-Software und/oder ein Software-Reset zum Neueinlesen von Variablenwerten von Variablen der zu testenden Steuergeräte-Software simuliert wird.

4. Verfahren nach einem der vorangehenden Ansprüche, wobei das Simulieren des Resetereignisses aufweist, dass als Teil der Simulation zumindest eine vordefinierte Resetfunktion der zu testenden Steuergeräte-Software ausgeführt wird,
wobei vorzugsweise, nachdem die Resetfunktion als Teil der Simulation zumindest teilweise ausgeführt wurde, der erste Speicherbereich (9) zumindest teilweise auf das vordefinierte Speicherabbild (109) gesetzt wird.

5. Verfahren nach einem der vorangehenden Ansprüche, wobei während des Simulierens des Resetereignisses keine durch das Simulieren des Resetereignisses bedingte Unterbrechung der Verbindung zu anderen Simulationsteilnehmern erfolgt.

6. Verfahren nach einem der vorangehenden Ansprüche, wobei, insbesondere innerhalb der Simulation, das virtuelle Steuergerät zumindest teilweise bereitgestellt wird durch einen ersten Softwareanteil (105) der die zu testende Steuergeräte-Software zumindest teilweise bereitstellt, und einen zweiten Softwareanteil (107), der ein Modell von zumindest Teilen der Ziel-Hardware zumindest teilweise bereitstellt,
wobei vorzugweise
(i) das Simulieren des Resetereignisses aufweist, dass ein Verlauf der Simulation durch spezifische Einwirkungen beeinflusst wird, die auf ein Einbeziehen des ersten Softwareanteils (105) und/oder auf ein Einbeziehen des zweiten Softwareanteils (107) zurückzuführen sind,
wobei vorzugsweise die spezifischen Einwirkungen, die auf das Einbeziehen des ersten Softwareanteils (105) zurückzuführen sind, den Simulationsverlauf zumindest teilweise von innerhalb der Simulation beeinflussen und/oder die spezifischen Einwirkungen, die auf das Einbeziehen des zweiten Softwareanteils (107) zurückzuführen sind, den Simulationsverlauf zumindest teilweise von außerhalb der Simulation beeinflussen,
(ii) die spezifischen Einwirkungen, die auf das Einbeziehen des ersten Softwareanteils (105) zurückzuführen sind, aufweisen, dass die vordefinierte Resetfunktion der zu testenden Steuergeräte-Software durch den ersten Softwareanteil (105) bereitgestellt werden, und/oder die spezifischen Einwirkungen, die auf das Einbeziehen des zweiten Softwareanteils (107) zurückzuführen sind, aufweisen, dass der erste Speicherbereich (9) zumindest teilweise durch den zweiten Softwareanteil (107) auf das vordefinierte Speicherabbild (109) gesetzt wird,
und/oder
(iii) das Simulieren des Resetereignisses aufweist, dass die spezifischen Einwirkungen, die auf das Einbeziehen des ersten Softwareanteils (105) zurückzuführen sind, beendet oder unterbrochen werden und die spezifischen Einwirkungen, die auf das Einbeziehen des zweiten Softwareanteils (107) zurückzuführen sind, begonnen oder fortgesetzt werden.

7. Verfahren nach Anspruch 6, wobei der erste Softwareanteil (105) und der zweite Softwareanteil (107) durch eine gemeinsame DLL-Datei (103) bereitgestellt werden.

8. Verfahren nach einem der vorangehenden Ansprüche, wobei die Simulation auf einer auf der Host-Datenverarbeitungsvorrichtung (1) laufenden Simulationsplattform (101) durchgeführt wird, und vorzugsweise die Durchführung der Simulation aufweist, dass die DLL-Datei (103) in die Simulationsplattform (101) und/oder in eine zumindest den ersten Speicherbereich (9) aufweisende Speichereinheit der Host-Datenverarbeitungsvorrichtung (1) geladen wird.

9. Verfahren nach einem der vorangehenden Ansprüche, wobei durch die Simulation das Resetereignis simuliert wird und/oder dass durch die Simulation ein Verhalten des virtuellen Steuergerätes und/oder der zu testenden Steuergeräte-Software aufgrund des Resetereignisses simuliert wird.

10. Vorrichtung zur Datenverarbeitung zum Durchführen einer SIL-Simulation, die Vorrichtung aufweisend Mittel, die dazu eingerichtet sind, ein Verfahren nach einem der Ansprüche 1 bis 9 auszuführen.

11. Computerprogrammprodukt, umfassend Befehle, die bei der Ausführung des Programms durch eine Vorrichtung zur Datenverarbeitung, insbesondere die Vorrichtung zur Datenverarbeitung nach Anspruch 10, diese veranlassen, ein Verfahren nach einem der Ansprüche 1 bis 9 auszuführen.

12. Signalfolge, die insbesondere über ein Computernetzwerk übermittelbar ist, wobei die Signalfolge Daten zumindest einer DLL-Datei (103) repräsentiert, welche DLL-Datei (103) in einem Verfahren nach einem der Ansprüche 1 bis 9, in Verbindung mit zumindest einigen Merkmalen der Ansprüche 6 und 7, verwendbar ist.

13. Simulationsplattform (101), die dazu eingerichtet ist, zumindest eine DLL-Datei (103) entweder nach Anspruch 7 und/oder die durch eine Signalfolge nach Anspruch 12 übertragbar ist einzuladen.
